# EUROPÄISCHE PATENTSCHRIFT

(11) **EP 1 173 867 B1**
(45) Veröffentlichungstag und Bekanntmachung des Hinweises auf die Patenterteilung: **13.08.2003**
(21) Anmeldenummer: 00940125.8
(22) Anmeldetag: 17.04.2000
(51) Int. Cl.: H01H 71/10, H01H 71/02

(54) **VERBINDUNGSVORRICHTUNG FÜR BAUELEMENTE, INSBESONDERE FÜR GEHÄUSETEILE VON LEITUNGSSCHUTZSCHALTERN**
LINKING DEVICE FOR COMPONENTS, ESPECIALLY FOR HOUSING PARTS OF AUTOMATIC CUTOUTS
DISPOSITIF D'ASSEMBLAGE POUR COMPOSANTS, NOTAMMENT POUR ELEMENTS DE BOITIER DE DISJONCTEURS DE PROTECTION

(30) Priorität: 29.04.1999 DE 19919540
(43) Veröffentlichungstag der Anmeldung: 23.01.2002
(73) Patentinhaber: SIEMENS AKTIENGESELLSCHAFT, 80333 München (DE)
(72) Erfinder: SCHMID, Josef, D-93183 Kallmünz (DE); FRANZ, Bernhard, D-93059 Regensburg (DE); LEITL, Wolfgang, D-93173 Wenzenbach (DE)
(86) Internationale Anmeldenummer: DE0001201
(87) Internationale Veröffentlichungsnummer: WO00067277

(56) Entgegenhaltungen:
- DE-A- 4 420 766
- DE-U- 8 322 594
- FR-A- 1 590 867
- FR-A- 2 576 140

## Beschreibung

Die Erfindung bezieht sich auf eine Verbindungsvorrichtung für eine Anzahl von Bauelementen, mit einem Verbindungselement, das einen in der Verbindung miteinander fluchtende Durchgangsöffnungen durchsetzenden Schaft mit einem Einführende und mit einem diesem gegenüberliegenden Halteende aufweist, wobei durch Verdrehen des Verbindungselements die Bauelemente gegeneinander verspannbar sind. Unter Bauelemente werden hierbei insbesondere Gehäuseteile oder -schalen von Reiheneinbau- oder Niederspannungsschaltgeräten, z.B. von Leitungsschutzschaltern, verstanden.

Leitungsschutzschalter und andere Reiheneinbaugeräte sowie deren Gehäuseteile oder -hälften werden üblicherweise mittels Schrauben und Muttern, Klammern oder Nieten ein- und mehrpolig verbunden, wobei je Pol eine Gehäuseschale und eine Dekkelschale miteinander zu verbinden sind. Derartige Verbindungen sollen einerseits kostengünstig und einfach herzustellen sowie leicht zu montieren sein. Andererseits sollen von den Verbindungen infolge von Lichtbogeneinflüssen auftretende Druckspannungen aufgenommen und Toleranzen kompensiert werden, während Quellungen und Nachschwingungen der Gehäuseschalen unter Klimabedingungen zuzulassen sind. Auch soll eine bestimmte Vorspannkraft auf die Gehäuseschalen ausgeübt werden, um sowohl einen Verdrehschutz der zu verbindenden Teile sicherzustellen als auch einen Schutz gegen ungewünschtes Lösen der Verbindung zu gewährleisten.

Während eine Verschraubung der Bauteile oder Gehäuseschalen miteinander einerseits kostenintensiv ist und andererseits die Schraubverbindung gegen unbeabsichtigtes Lösen beispielsweise mittels Lack zu sichern ist, bietet eine Nietverbindung in deren Längsrichtung nur einen geringen Toleranzausgleich.

Dies gilt insbesondere dann, wenn die auszugleichenden Toleranzen sich summieren. Zudem knicken Nietverbindungen beim Nietvorgang mit relativ langen Nieten leicht aus. Außerdem werden für den Verdrehschutz der einzelnen Pole bisher häufig zusätzliche Zentrierstücke eingesetzt, was jedoch zusätzliche Fertigungs- und Herstellungskosten verursacht.

Bei einer ebenfalls häufig eingesetzten Klammer-Verbindung müssen in ebenfalls kostenintensiver Art und Weise mindestens zwei Klammern verwendet werden. Dabei sind die Pole einerseits zueinander nur mit geringer Spannkraft verspannt, während andererseits die Klammern mit der Folge einer Manipulationsgefahr leicht lösbar sind. Eine ebenfalls bisher verwendete Klebeverbindung erlaubt keine zerstörungsfreie. Demontage der einzelnen Bauelemente und gewährleistet zudem keine ausreichende Verspannung der Bauteile miteinander.

Aus dem deutschen Gebrauchsmuster DE 83 22 594 U1 ist ein aus einem Flachbandmaterial gefertigtes Verbindungselement beispielsweise auch für Leitungsschutzschalter mit einem länglichen Schaft bekannt, dessen beiden Schaftenden durch angeformte Nasen T-förmig ausgestaltet sind. Zum Einführen des bekannten Verbindungselements in die miteinander fluchtenden Durchgangsöffnungen oder Bohrungen der zu verbindenden Bauteile ist eines der Schaftenden derart geschlitzt, dass die T-förmig ausgestellten Halte- oder Fixiernasen in Richtung auf die Schaftlängsachse verschränkt werden können. Zwar ist dadurch eine Anpassung dieses Schaftendes an die Schaftbreite erreicht. Allerdings führt diese Ausgestaltung zwangsläufig zu einer Querschnittsschwächung des Schaftes und damit des Verbindungselements mit der Folge, dass der Querschnitt auf der gesamten Schaftlänge durch äquidistante Bohrungen gezielt geschwächt werden muss. Dadurch kann zwar eine gleichmäßige Materialbelastung erreicht und eine Sollbruchstelle vermieden werden. Allerdings führt diese Querschnitts-Schwächung zu einer erheblichen Reduzierung des belastbaren Schaftquerschnitts und damit zu einer Reduzierung der Verspannkraft, die durch ein Verdrillen des Schaftes mit der Folge einer Längenreduzierung des Verbindungselements erzielt werden soll. Zudem muss in aufwendiger Art und Weise beim Verdrillen der gesamte, durch ein Langloch verlängerte Schlitz am entsprechenden Schaftende mittels eines Werkzeugs überdeckt und das gegenüberliegende Schaftende gehalten werden, um einerseits dieses Schaftende gegen ein Mitdrehen zu sichern, und um andererseits eine möglichst gleichmäßige Zug- und damit Verspannkraft an den Schaftenden zu erzielen. Ferner ist aufgrund des komplizierten Ein- und Ausbiegemechanismus mit dem geschlitzten Schaftende eine mehrfache Verdrillung erforderlich, um die für eine Verspannung der Bauteile ausreichende Längenverkürzung des Verbindungselements zu erzielen.

Der Erfindung liegt daher die Aufgabe zugrunde, eine Verbindungsvorrichtung der eingangs genannten Art anzugeben, bei dem die genannten Nachteile vermieden sind.

Diese Aufgabe wird erfindungsgemäß gelöst durch die Merkmale des Anspruchs 1. Alternativ wird diese Aufgabe erfindungsgemäß durch die Merkmale des Anspruchs 2 gelöst. Das Verbindungselement weist dazu am Einführende zwei in einem Ausgangszustand kreisbogenförmig eingebogene Fixierlaschen auf, die im Montagezustand radial ausgebogen sind. Alternativ sind am Einführende des Verbindungselements zwei sich in einem Ausgangszustand gabelartig in Schaftlängsrichtung erstrekkende Fixierlaschen vorgesehen, die im Montagezustand radial ausgebogen sind.

Bei beiden Alternativen liegt dieses auch als Einführende dienende Schaftende im Montagezustand vor dem Verdrehen des vorzugsweise aus einem Flachbandmaterial durch Stanzung gefertigten Verbindungselements zweckmäßigerweise formschlüssig in einer dem Einführende zugeordneten und in die entsprechende Durchgangsöffnung mündende Montagevertiefung ein.

Bei der ersten Alternative ist das dem Halteende gegenüberliegende Einführende in einem Fertigungszustand zunächst zweckmäßigerweise T-förmig ausgestaltet, um es anschließend zur Anpassung an die Außenabmessung des Schaftes durch einen Biegevorgang in den Ausgangszustand mit kreisförmig einwärts gebogenen Fixierlaschen zu überführen. Im Montagezustand, d.h. nach dem Einführen des Verbindungselements in die Durchgangsöffnungen, werden die Fixierlaschen dann radial ausgebogen.

Um dabei die Ausbiegung der Fixierlaschen am Einführende außerhalb des diesem zugewandten Bauelements oder Gehäuseteils vornehmen zu können, ist eine das gegenüberliegende Halteende des Verbindungselements aufnehmende Montagevertiefung zweistufig ausgebildet. Die stufige Innenkontur ist zweckmäßigerweise durch zwei zueinander winklig, vorzugsweise rechtwinklig, verlaufende Einkerbungen unterschiedlicher Kerbentiefe gebildet, die zwei verschiedene Haltepositionen definieren.

Bei Lagefixierung des Verbindungselements über dessen Halteende in einer ersten, vergleichsweise tiefen Position innerhalb der das Halteende aufnehmenden Montagevertiefung ragt das mit den Fixierlaschen versehene Einführende aus der diesem zugeordneten Montagevertiefung heraus und über die Bauelemente- oder Gehäuseanordnung hinaus, so dass in einfacher Weise die Fixierlaschen radial ausgebogen werden können. Im Anschluss an diesen Biegevorgang wird das Verbindungselement zurückgezogen und in einer zweiten Position lagefixiert, die gegenüber der ersten Position axial nach außen verschoben oder versetzt ist. Dabei wird gleichzeitig das Einführende vollständig in die diesem zugeordnete Montagevertiefung hineingezogen.

Anschließend kann durch Verdrillen des Schaftes des Verbindungselements die gewünschte Verspannkraft zum Verspannen der Bauelemente oder Gehäuseteile miteinander erzeugt werden. Dabei wird ein entsprechendes Verdrillwerkzeug am mit den ausgebogenen Fixierlaschen versehenen Einführende angesetzt. Diese Ausführungsform eignet sich besonders zur Verbindung mehrpoliger Leitungsschutzschalter mit einer entsprechenden Mehrzahl von Gehäuse- und Deckelschalen.

Bei der zweiten Alternative mit gabelartig ausgestaltetem Einführende des Verbindungselements sind die beiden sich in einem Ausgangszustand in Schaftlängsrichtung erstreckende Fixierlaschen derart an das Schaftende angeformt, dass diese eine direkte, geradlinige Verlängerung des Schaftes ohne seitlichen Überstand bilden. Die vorzugsweise durch eine Ausstanzung am Einführende gebildeten und zueinander parallel verlaufenden Fixierlaschen werden im Montagezustand radial ausgebogen, wobei die Ausbiegung sowohl in oder als auch quer zur Schaftebene erfolgen kann.

Bei dieser Ausführungsform wird das Verbindungselement wiederum nach Herstellung des Formschlusses durch Ausbiegen der Fixierlaschen verdrillt. Dabei ist ebenfalls aufgrund des Formschlusses im Montagezustand die Anzahl der beim Tordieren des Schaftes herzustellenden Windungen besonders gering, insbesondere lediglich einfach.

In vorteilhafter Weiterbildung ist eine das Halteende des Verbindungselements aufnehmende und mit den Durchgangsöffnungen fluchtende Montagevertiefung als Zentrierkegel ausgebildet, wobei das Halteende selbst unter Bildung einer mit dem Zentrierkegel korrespondierenden Anzugsfläche konisch ausgebildet ist. Dadurch wird eine zuverlässige Selbstzentrierung des Verbindungselements innerhalb der miteinander fluchtenden Durchgangsbohrungen der Bauelemente erzielt. Gleichzeitig wird beim Verdrehen des Verbindungselements eine über dessen Querschnitt gleichmäßige Zugkraft auf das gegenüberliegende Schaftende ausgeübt. Zudem wird vorteilhafterweise aufgrund der vergleichsweise großen miteinander korrespondierenden Anzugsflächen des Zentrierkegels einerseits und des Zentrierkonus am Halteende andererseits eine zur Vermeidung eines Mitdrehens des Halteendes ausreichende Reibkraft erzeugt. Ein beidseitiges Festhalten des Verbindungselements an dessen beiden Schaftenden ist daher nicht erforderlich.

Die mit der Erfindung erzielten Vorteile bestehen insbesondere darin, dass durch Einsetzen eines zweckmäßigerweise flachbandartigen Verbindungselements mit im Ausgangszustand entweder kreisförmig eingebogenen oder sich ohne radialen Überstand über die Schaftaußenabmessung hinaus in Schaftlängsrichtung erstreckenden Fixierlaschen ein besonders einfaches Einführen des Verbindungselements in miteinander fluchtende Durchgangsöffnungen von miteinander zu verbindenden Bauelementen möglich ist. Darüber hinaus ist unter Vermeidung einer Materialschwächung ein Verspannen der Bauelemente miteinander durch eine nur einhalb- oder einfache (1/2-fach bzw. 1-fach) Verdrillung des Verbindungselements möglich.

Das dazu vorgesehene Verbindungselement ist einerseits besonders einfach und andererseits aufgrund des ungeschwächten Materialquerschnitts, d.h. insbesondere ungelochten und ungeschlitzten Schaftes, besonders stabil ausgeführt. Auch ist die Verbindung vor Ort in besonders einfacher Art und Weise herstellbar. Bei Verwendung von verzinktem Stahlband oder nicht rostendem Material ist zudem ein zuverlässiger Korrosionsschutz gegeben. Wesentlicher Vorteil ist, dass bereits vorhandene Niet- oder Schraubenlöcher in den Gehäuseteilen verwendet werden können.

Aufgrund des bereits im Montagezustand und vor dem Verdrehen oder Verdrillen des Verbindungselements durch radiales aus- bzw. umbiegen der Fixierlaschen hergestellten Formschlusses am Einführende des Schaftes ist die zum Aufbringen der erforderlichen Verspannkraft notwendige Längenreduzierung des Verbindungselements und damit die erforderliche Torsionsstrecke besonders gering und insbesondere gegenüber dem genannten Stand der Technik nach DE 83 22 594 U1 erheblich verkürzt.

Über die Ausbildung eines Zentrierkegels in der ein entsprechend konisches Halteende des Verbindungselements aufnehmenden Montagevertiefung wird zudem einerseits eine Zentrierung und andererseits eine hohe Reibkraft erreicht, so dass beim Verspannen der Bauelemente eine besonders hohe Spannkraft bei gleichzeitig einfacher Handhabung erzielt wird. Außerdem wird beim Verdrehen des Verbindungselements zum Verspannen der Bauelemente bei gleichzeitiger Selbstzentrierung des Verbindungselements ein besonders geringer Verdreh- oder Verdrillweg erreicht. Dabei ist auch bei mehrpoligen Geräten mit einer entsprechenden Mehrzahl von Gehäuseteilen oder -schalen für jede derartige Verbindungsstelle lediglich ein Verbindungsteil erforderlich.

Nachfolgend werden Ausführungsbeispiele der Erfindung anhand einer Zeichnung näher erläutert. Darin zeigen:
- FIG 1: in perspektivischer Darstellung ein flachbandartiges, I-förmiges Verbindungselement,
- FIG 2: in Draufsicht (obere Figurenhälfte) und in einer Seitenansicht (untere Figurenhälfte) ein Verbindungselement gemäß FIG 1 mit kreisförmig eingebogenen Fixierlaschen am Einführende,
- FIG 3 bis 6: jeweils in Draufsicht (obere Figurenhälfte) und in einem Längsschnitt (untere Figurenhälfte) den Verbindungsbereich zweier Gehäuseteile mit dem Verbindungselement gemäß FIG 2 in verschiedenen Montagezuständen, wobei in den. Figuren 5 und 6 ein gegenüber den Figuren 3 und 4 um 90° versetzter Längsschnitt dargestellt ist,
- FIG 7: in einer Darstellung gemäß FIG 6 die Verbindung eines zweipoligen Gerätes,
- FIG 8: in perspektivischer Darstellung eine alternative Ausführungsform des Verbindungselements mit gabelartigem Einführende,
- FIG 9: in perspektivischer Darstellung die Verbindungsvorrichtung mit dem Verbindungselement gemäß FIG 8,
- FIG 10: eine modifizierte Ausführungsform des Verbindungselements gemäß FIG 8, und
- FIG 11: in einer Darstellung gemäß FIG 9 eine Verbindungsvorrichtung unter Verwendung des Verbindungselements gemäß FIG 10.

Einander entsprechende Teile sind in allen Figuren mit den gleichen Bezugszeichen versehen.

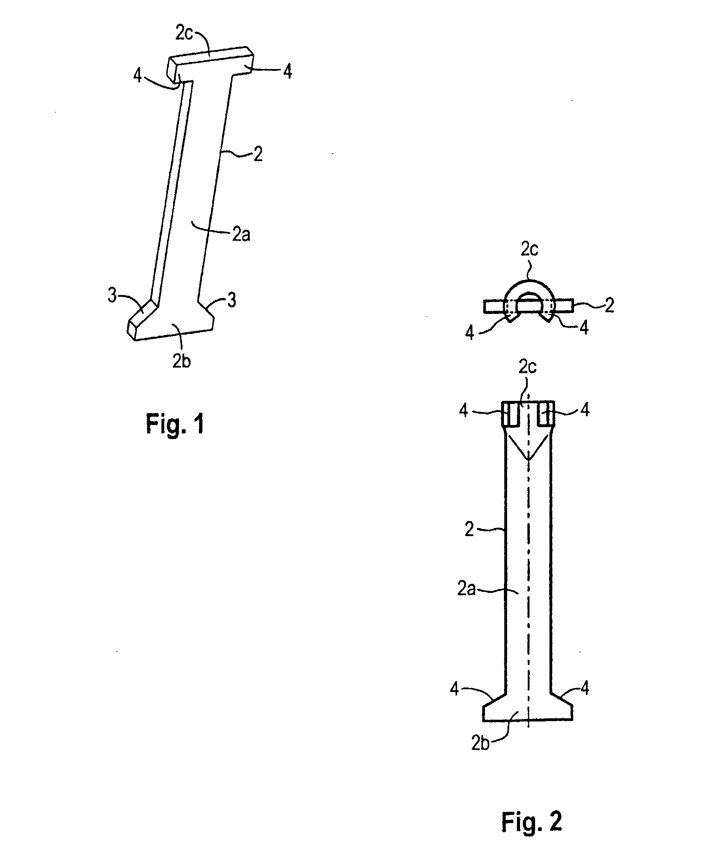

FIG 1 zeigt ein aus einem Flachbandmaterial gestanztes I-förmiges Verbindungselement 2 mit einem länglichen Schaft 2a, dessen Schaftenden 2b und 2c etwa T-förmig nach außen ausgestellt sind. Dabei ist das nachfolgend als Halteende bezeichnete Schaftende 2b konisch ausgebildet, wobei der Konus zur Ausbildung von Anzugsflächen 3 auf den Schaft 2 gerichtet ist. Das gegenüberliegende, nachfolgend als Einführende bezeichnete Schaftende 2c weist zwei radial nach außen gerichtete Fixierlaschen oder -elemente 4 auf.

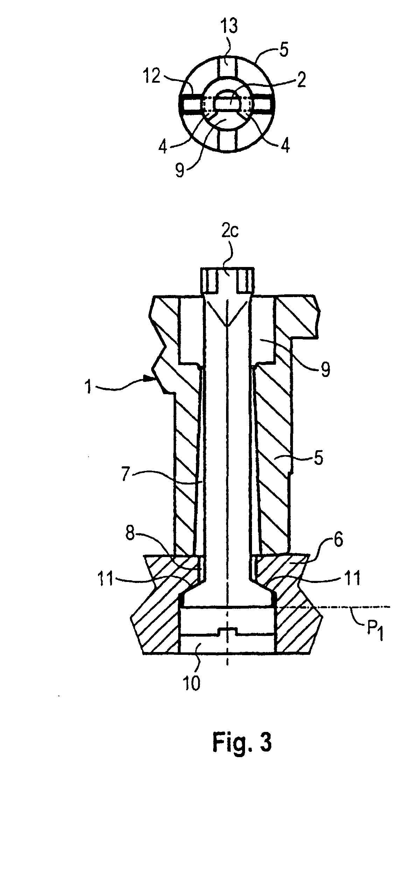

In einer Verbindungsvorrichtung 1 gemäß den Figuren 3 bis 6 sowie 9 und 11 dient das Verbindungselement 2 zum Verbinden einer Gehäuseschale 5 und einer Deckelschale 6, beispielsweise eines Leitungsschutzschalters. Die Bauelemente oder Gehäuseteile 5,6 sind mit miteinander fluchtenden Durchgangsöffnungen 7 bzw. 8 versehen, in die jeweils eine Montagevertiefung 9 bzw. 10 mündet. Die im Ausführungsbeispiel der Dekkelschale 6 zugeordnete erste Montagevertiefung 10 ist mit einem mit den Anzugsflächen 5 des konischen Halteendes 2b des Verbindungselements 2 korrespondierenden Zentrierkegel 11 versehen, dessen Innendurchmesser sich auf den Innendurchmesser der Durchgangsbohrungen 7,8 verjüngt.

Bei dem in FIG 2 dargestellten Ausgangszustand sind die Fixierlaschen 4 des Verbindungselements 2 ausgehend von dessen Form gemäß FIG 1 am dem Halteende 2b gegenüberliegenden Einführende 2c durch einen Biegevorgang auf die Außenabmessung des Schaftes 2 reduziert, indem die beiden Fixierlaschen 4 kreis- oder kreisbogenförmig eingebogen sind. In diesem Ausgangszustand ist das Verbindungselement 2 durch die miteinander fluchtenden Durchgangsbohrungen 7,8 der Gehäuseteile 5 bzw. 6 durchsteckbar. Diesen Montagezustand zeigt die FIG 3 in einem Längsschnitt (untere Figurenhälfte) und in einer Draufsicht auf das Einführende 2c (obere Figurenhälfte). In diesem Montagezustand liegt das Halteende 2b des Verbindungselements 1 innerhalb der Montagevertiefung 10 in einer ersten, vergleichsweise tiefen Position P₁. Dazu ist die Montagevertiefung 10 entsprechend stufig ausgebildet, wobei zur Stufenbildung zwei radial und zueinander rechtwinklig verlaufende Vertiefungen oder Einkerbungen 12,13 vorgesehen sind. Dies ist aus der oberen Figurenhälfte der FIG 3 ersichtlich.

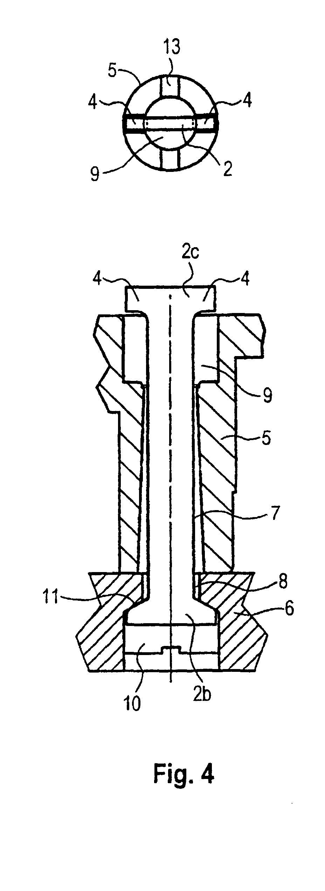

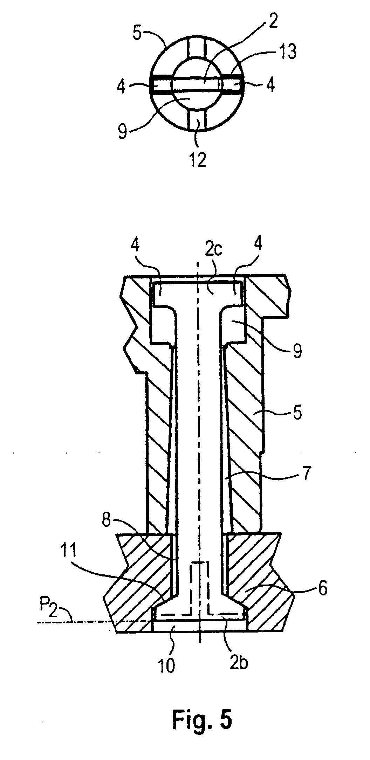

In einem nächsten Montageschritt gemäß FIG 4 werden die beiden Fixierlaschen 4 am Einführende 2c des Verbindungselements 2 radial ausgebogen, wobei der Ausbiegevorgang aufgrund der tiefen Einlagerung des konischen Halteendes 2b in der Position P₁ außerhalb des Gehäuseteils 5 erfolgen kann. In einem anschließenden Montageschritt gemäß FIG 5 wird das Verbindungselement 2 um ca. 90° gegenüber der Lage nach den Figuren 3 und 4 verdreht, wobei das konische Halteende 2b in einer zweiten, axial nach außen versetzten Position P₂ lagefixiert ist. In diesem Montagezustand liegen beide Schaftenden 2b und 2c innerhalb der diesen zugeordneten Montagevertiefungen 9 bzw. 10 vollständig ein. Dabei liegen die Anzugsflächen 3 des konischen Halteendes 2b bereits an den korrespondierenden Konusflächen des Zentrierkegels 11 innerhalb der Montagevertiefung 10 an.

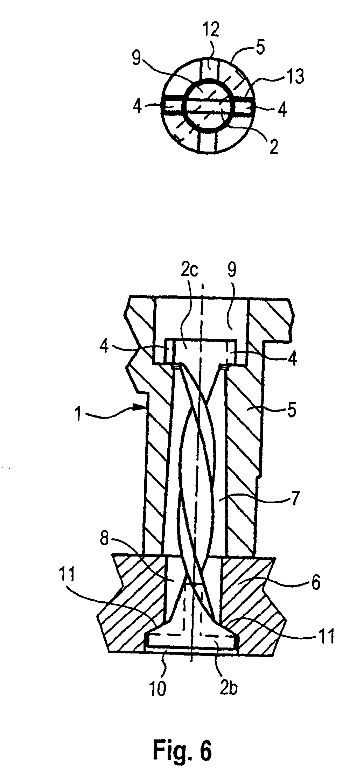

In einem letzten Montageschritt wird der Schaft 2 des Verbindungselements 2 tordiert. Dazu greift zum Verdrillen des Verbindungselements 2 ein entsprechendes (nicht dargestelltes) Werkzeug lediglich am Einführende 2c an, während das gegenüberliegende Halteende 2b aufgrund des Reibschlusses zwischen der Anzugsfläche 3 des konischen Halteendes 2b und der mit dieser korrespondierenden Gegenfläche des Zentrierkegels 11 nicht festgehalten werden muß. Dieser Zustand, bei der die beiden Gehäuseteile 5 und 6 miteinander verspannt sind, ist in FIG 6 dargestellt. Darin ist auch erkennbar, dass lediglich eine einzelne Torsionswindung, d.h. eine 360°-Drehung des Einführendes 2c, zum Verspannen der Gehäuseteile 5,6 erforderlich ist.

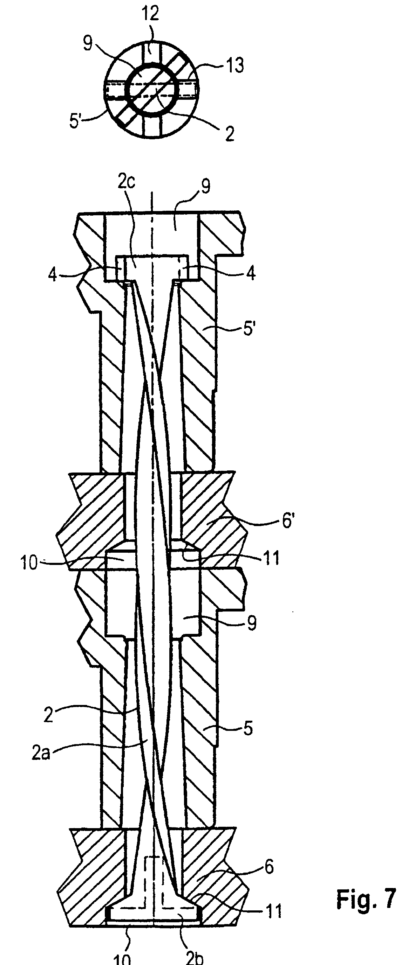

FIG 7 zeigt eine entsprechende Ausführungsform der Verbindung eines zweipoligen Gerätes mit übereinanderliegenden Gehäuseteilen 5,6 und 5',6' in einer Darstellung gemäß FIG 6. Das Verbindungselement 2 ist gegenüber der Ausführungsform gemäß den Figuren 3 bis 6 entsprechend etwa doppelt so lang wie das Verbindungselement 2 für ein einpoliges Gehäuse.

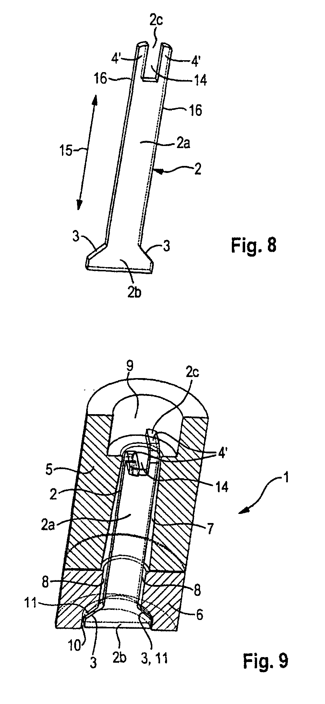

FIG 8 zeigt eine weitere Ausführungsform des Verbindungselements 2, dessen Montagezustand in FIG 9 dargestellt ist. Bei dieser Ausführungsform ist das Verbindungselement 2 an dessen Einführende 2c gabelartig ausgestaltet und mit zwei sich unter Bildung eines rechteckförmigen Schlitzes 14 in Schaftlängsrichtung 15 erstreckenden Fixierlaschen 4' versehen. Diese fingerartig sich zueinander und in Schaftlängsrichtung 15 parallel erstreckenden Fixierlaschen 4' bilden praktisch eine direkte Verlängerung des Schaftes 2a, ohne dass die Fixierlaschen 4' seitlich über die Ausdehnung des Schaftes 2a hinausragen. Mit anderen Worten: die Seitenaußenkanten 16 des Schaftes 2a gehen in Richtung des Einführendes 2c in direkter Flucht in die Seitenaußenkanten der Fixierlaschen 4' über.

Nach Einführen des Verbindungselements 2 durch die miteinander fluchtenden Durchgangsbohrungen 7,8 der zu verspannenden Gehäuseteile 5 bzw. 6 liegen die Anzugsflächen 3 des konischen Halteendes 2b wiederum an der korrespondierenden Gegenfläche des Zentrierkegels 11 innerhalb der Montagevertiefung 10 reibschlüssig an. Dadurch ist das Verbindungselement 2 wiederum innerhalb der Durchgangsöffnungen 7,8 zentriert. Durch Umbiegen der beiden Fixierlaschen 4' in entgegengesetzte Richtung und quer zur Ebene des Schaftes 2 wird bereits eine formschlüssige Lagefixierung des Verbindungselements 2 innerhalb der miteinander fluchtenden Durchgangsbohrungen 7,8 erzielt. Durch Verdrillen des Schaftes 2 mittels des wiederum nur einseitig angreifenden Werkzeugs wird die gewünschte Anzugskraft oder Verspannkraft erzielt.

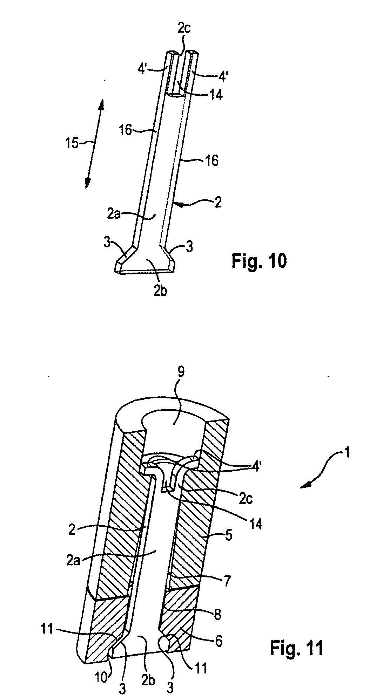

Eine alternative Verbindungsvorrichtung 1 zeigt FIG 11, bei der die beiden Fixierlaschen 4' im Unterschied zu der Ausführungsform gemäß FIG 9 in der Ebene des Schaftes 2 in entgegengesetzter Richtung radial nach außen gebogen sind. Ein dazu vorzugsweise eingesetztes Verbindungselement 2 ist gemäß FIG 10 mit stumpfen Enden der Fixierlaschen 4' ausgeführt, während diese bei dem Verbindungselement 2 gemäß FIG 8 nach außen abgerundet sind. Auch hier entsteht ein Formschluss, wobei die nötige Verspannkraft wiederum durch Verdrillen am gegenüberliegenden Halteende 2b erzeugt wird.

Gegenüber der Variante gemäß FIG 11 hat die Verbindungsvorrichtung 1 gemäß FIG 9 den Vorteil einer größeren Auflagefläche der Fixierlaschen 4'. Außerdem wird eine Verbindung mit besonders hoher Elastizität erreicht. Ferner sind die Verbindungen gemäß den Figuren 9 und 11 lösbar, indem durch weitere Drehung des Halteendes 2b die Fixierlaschen 4' einwärts gebogen werden, bis das Verbindungselement 2 aus den Durchgangsbohrungen 7,8 herausgezogen werden kann.

## Patentansprüche

1. Verbindungsvorrichtung für eine Anzahl von Bauelementen (5,6), mit einem Verbindungselement (2), das einen in der Verbindung miteinander fluchtende Durchgangsöffnungen (7,8) durchsetzenden Schaft (2a) mit einem Einführende (2c) und mit einem diesem gegenüberliegenden Halteende (2b) aufweist, wobei durch Verdrehen des Verbindungselements (2) die Bauelemente (5,6) gegeneinander verspannbar sind,
**dadurch gekennzeichnet, dass** das Verbindungselement (2) am Einführende (2c) zwei in einem Ausgangszustand kreisbogenförmig eingebogene Fixierlaschen (4) aufweist, die im Montagezustand radial ausgebogen sind.

2. Verbindungsvorrichtung für eine Anzahl von Bauelementen (5,6), mit einem Verbindungselement (2), das einen in der Verbindung miteinander fluchtende Durchgangsöffnungen (7,8) durchsetzenden Schaft (2a) mit einem Einführende (2c) und mit einem diesem gegenüberliegenden Halteende (2b) aufweist, wobei durch Verdrehen des Verbindungselements (2) die Bauelemente (5,6) gegeneinander verspannbar sind,
**dadurch gekennzeichnet, dass** am Einführende (2c) des Verbindungselements (2) zwei sich in einem Ausgangszustand gabelartig in Schaftlängsrichtung (14) erstrekkende Fixierlaschen (4') vorgesehen sind, die im Montagezustand radial ausgebogen sind.

3. Verbindungsvorrichtung nach Anspruch 1,
**dadurch gekennzeichnet, dass** eine das Halteende (2b) aufnehmende und mit den Durchgangsöffnungen (7,8) fluchtende Montagevertiefung (10) eine stufige Innenkontur (12,13) aufweist, die infolge eines Verdrehens des Verbindungselements (2) das Halteende (2b) innerhalb der Montageöffnung (10) in einer gegenüber einer ersten Position (P₁) axial versetzten zweiten Position (P₂) hält.

4. Verbindungsvorrichtung nach Anspruch 3,
**dadurch gekennzeichnet, dass** die stufige Innenkontur durch zwei zueinander winklig, vorzugsweise rechtwinklig, verlaufende Einkerbungen (12,13) gebildet ist.

5. Verbindungsvorrichtung nach Anspruch 2,
**dadurch gekennzeichnet, dass** sich die fingerartig in Schaftlängsrichtung (15) erstreckenden Fixierlaschen (4') eine direkte Verlängerung der Seitenaußenkanten (16) des Schaftes (2a) bilden derart, dass die Seitenaußenkanten (16) in Richtung des Einführendes (2c) in direkter Flucht und überstandslos in die Fixierlaschen (4') übergehen.

6. Verbindungsvorrichtung nach Anspruch 2 oder 5,
**dadurch gekennzeichnet, dass** die Fixierlaschen (4') im Montagezustand in der oder quer zur Schaftebene des Verbindungselements (2) ausgebogen sind.

7. Verbindungsvorrichtung nach Anspruch 6,
**dadurch gekennzeichnet, dass** die beiden Fixierlaschen (4') in entgegengesetzter Richtung ausgebogen sind.

8. Verbindungsvorrichtung nach einem der Ansprüche 1 bis 7,
**dadurch gekennzeichnet, dass** eine das Halteende (2b) aufnehmende und mit den Durchgangsöffnungen (7,8) fluchtende Montagevertiefung (10) als Zentrierkegel (11) ausgebildet ist, und dass das Halteende (2b) unter Bildung einer mit dem Zentrierkegel (11) korrespondierenden Anzugsfläche (3) konisch ausgebildet ist.

9. Verbindungsvorrichtung nach einem der Ansprüche 1 bis 8,
**dadurch gekennzeichnet, dass** das Verbindungselement (2) flachbandartig und über die gesamte Schaftlänge ungeschwächt, insbesondere ungelocht sowie ungeschlitzt, ausgebildet ist.

10. Verbindungsvorrichtung nach einem der Ansprüche 1 bis 9,
**dadurch gekennzeichnet, dass** das Verbindungselement (2) entlang des Schaftes (2a) verdrillbar ist.

## Claims

1. A connecting apparatus for a number of components (5, 6), having a connecting element (2) which has a shaft (2a) which passes through through-openings (7, 8) which are aligned with one another in the connection, having an insertion end (2c) and having a holding end (2b) opposite it, in which case the components (5, 6) can be braced with respect to one another by twisting the connecting element (2), **characterized in that**, at the insertion end (2c), the connecting element (2) has two fixing lugs (4) which are bent in in the form of a circular arc in an initial state and are bent out radially in the mounting state.

2. A connecting apparatus for a number of components (5, 6), having a connecting element (2) which has a shaft (2a) which passes through through-openings (7, 8) which are aligned with one another in the connection, having an insertion end (2c) and having a holding end (2b) opposite it, in which case the components (5, 6) can be braced with respect to one another by twisting the connecting element (2), **characterized in that** two fixing lugs (4') are provided at the insertion end (2c) of the connecting element (2), extend like a fork, in an initial state, in the shaft longitudinal direction (14), and are bent out radially in the mounting state.

3. The connecting apparatus as claimed in Claim 1, **characterized in that** a mounting depression (10), which holds the holding end (2b) and is aligned with the through-openings (7, 8) has a stepped internal contour (12, 13) which, as a consequence of the connecting element (2) being twisted, holds the holding end (2b) within the mounting opening (10) in a second position (P₂), which is axially offset with respect to a first position (P₁).

4. The connecting apparatus as claimed in Claim 3, **characterized in that** the stepped internal contour is formed by two notches (12, 13) which run at an angle to one another, preferably at right angles.

5. The connecting apparatus as claimed in Claim 2, **characterized in that** the fixing lugs (4') which extend like fingers in the shaft longitudinal direction (15), form a direct extension of the side outer edges (16) of the shaft (2 a), such that the side outer edges (16) are aligned directly in the direction of the insertion end (2c) and merge into the fixing lugs (4') without any projection.

6. The connecting apparatus as claimed in Claim 2 or 5, **characterized in that**, in the mounting state, the fixing lugs (4') are bent out in or transversely with respect to the shaft plain of the connecting element (2) .

7. The connecting apparatus as claimed in Claim 6, **characterized in that** the two fixing lugs (9') are bent out in opposite directions.

8. The connecting apparatus as claimed in one of Claims 1 to 7, **characterized in that** a first mounting depression (10), which holds the holding end (2b) and is aligned with the through-openings (7, 8), has a centering cone (11), and **in that** the holding end (2b) is conical, forming a mating surface (3) which corresponds with the centering cone (11).

9. The connecting apparatus as claimed in one of Claims 1 to 8, **characterized in that** the connecting element (2) is in the form of a flat strip and has no weak point over the entire shaft length, in particular having no holes or slots.

10. The connecting apparatus as claimed in one of claims 1 to 9, **characterized in that** the connecting element (2) can be twisted along the shaft (2a).

## Revendications

1. Dispositif d'assemblage pour un certain nombre d'éléments (5, 6) de construction, comportant un élément (2) d'assemblage ayant un corps (2a) qui passe dans des ouvertures (7, 8) de passage mutuellement alignées lors de l'assemblage et qui est doté d'une extrémité (2c) d'introduction et d'une extrémité (2b) de maintien opposée à la précédente, les éléments (5, 6) de construction pouvant être assemblés l'un à l'autre avec serrage par rotation de l'élément (2) d'assemblage,
**caractérisé en ce que** l'élément (2) d'assemblage comporte, à l'extrémité (2c) d'introduction, deux pattes (4) d'immobilisation courbées vers l'intérieur en arc de cercle dans un état initial, qui sont courbées radialement vers l'extérieur dans l'état de montage.

2. Dispositif d'assemblage pour un certain nombre d'éléments (5, 6) de construction, comportant un élément (2) d'assemblage ayant un corps (2a) qui passe dans des ouvertures (7, 8) de passage mutuellement alignées lors de l'assemblage et qui est doté d'une extrémité (2c) d'introduction et d'une extrémité (2b) de maintien opposée à la précédente, les éléments (5, 6) de construction pouvant être assemblés l'un à l'autre avec serrage par rotation de l'élément (2) d'assemblage,
**caractérisé en ce qu'**il est prévu, à l'extrémité (2c) d'introduction de l'élément (2) d'assemblage, deux pattes (4') d'immobilisation qui, dans un état initial, s'étendent en fourche dans la direction (15) longitudinale du corps, et qui sont courbées radialement vers l'extérieur dans l'état de montage.

3. Dispositif d'assemblage suivant la revendication 1, **caractérisé en ce qu'**un renfoncement (10) de montage, recevant l'extrémité (2b) de maintien et aligné avec les ouvertures (7, 8) de passage, comporte un contour (12, 13) intérieur en gradin qui, à la suite d'une rotation de l'élément (2) d'assemblage, maintient l'extrémité (2b) de maintien à l'intérieur de l'ouverture (10) de montage dans une deuxième position (P₂) axialement décalée par rapport à une première position (P₁).

4. Dispositif d'assemblage suivant la revendication 3, **caractérisé en ce que** le contour intérieur en gradin est formé par deux encoches (12, 13) s'étendant en faisant entre elles un angle de préférence droit.

5. Dispositif d'assemblage suivant la revendication 2, **caractérisé en ce que** les pattes (4') d'immobilisation s'étendant à la manière de doigts dans la direction (15) longitudinale du corps forment un prolongement direct des bords (16) latéraux extérieurs du corps (2a), de telle sorte que les bords (16) latéraux extérieurs se poursuivent, en direction de l'extrémité (2c) d'introduction, en alignement direct et sans débordement par les pattes (4') d'immobilisation.

6. Dispositif d'assemblage suivant la revendication 2 ou 5, **caractérisé en ce que** les pattes (4') d'immobilisation sont, dans l'état de montage, courbées vers l'extérieur dans le plan du corps de l'élément (2) d'assemblage ou transversalement à ce plan.

7. Dispositif d'assemblage suivant la revendication 6, **caractérisé en ce que** les deux pattes (4') d'immobilisation sont courbées vers l'extérieur dans des directions opposées.

8. Dispositif d'assemblage suivant l'une des revendications 1 à 7, **caractérisé en ce qu'**un renfoncement (10) de montage recevant l'extrémité (2b) de maintien et aligné avec les ouvertures (7, 8) de passage est réalisé sous forme de cône (11) de centrage, et **en ce que** l'extrémité (2b) de maintien est réalisée conique, en formant une surface (3) de dépouille correspondant au cône (11) de centrage.

9. Dispositif d'assemblage suivant l'une des revendications 1 à 8, **caractérisé en ce que** l'élément (2) d'assemblage est réalisé à la manière d'une bande plate et non affaibli sur toute la longueur du corps, notamment ni percé ni fendu.

10. Dispositif d'assemblage suivant l'une des revendications 1 à 9, **caractérisé en ce que** l'élément (2) d'assemblage peut être tordu le long du corps (2a).
